# FASCICULE DE BREVET EUROPEEN

(11) **EP 2 629 593 B1**
(45) Date de publication et mention de la délivrance du brevet: **19.03.2014**
(21) Numéro de dépôt: 13305121.9
(22) Date de dépôt: 01.02.2013
(51) Int. Cl.: H05K 7/14

(54) **Dispositif support extractible pour équipement électrique.**
Herausziehbare Haltevorrichtung für elektrisches Gerät
Extractible support device for electric equipment

(30) Priorité: 14.02.2012 FR 1200416
(43) Date de publication de la demande: 21.08.2013
(73) Titulaire: Schneider Electric Industries SAS, 92500 Rueil-Malmaison (FR)
(72) Inventeur: Dubois, Denis-André, 38050 Grenoble Cedex 09 (FR); Loiodice, Robert, 38050 Grenoble Cedex 09 (FR)
(74) Mandataire: Colette, Marie-Françoise

(56) Documents cités:
- US-A- 5 010 426
- US-A- 5 668 696
- US-A- 5 721 669
- US-B2- 7 175 470

## Description

La présente invention concerne un dispositif support extractible comprenant un boîtier tiroir comportant au moins un connecteur dit premier, ledit boîtier tiroir étant destiné à s'insérer dans un boîtier fourreau comportant au moins un connecteur dit second, de manière à réaliser la connexion entre le ou les connecteur(s) dit(s) premier(s) et le ou les connecteur(s) dit(s) second(s), ledit boîtier tiroir étant muni d'une poignée ayant deux bras montés chacun à rotation autour d'un axe, lesdits bras pouvant occuper ensemble une première position dans laquelle ils s'étendent sensiblement perpendiculairement à une face du boîtier tiroir et une seconde position dans laquelle ces deux bras s'étendent dans un plan sensiblement parallèle à ladite face, ledit boîtier tiroir étant mobile par rapport au boîtier fourreau entre une première position dans laquelle ledit boîtier tiroir est extrait au moins en partie du boîtier fourreau, la poignée est dans la première position précitée, et les connecteurs dits premiers sont déconnectés des connecteurs dits seconds, et une seconde position dans laquelle le boîtier tiroir est complètement introduit à l'intérieur du boîtier fourreau, la poignée est dans la seconde position précitée et le ou les connecteur(s) dit premier(s) est(sont) connecté(s) au(x) connecteur(s) dit(s) second(s), et des moyens de verrouillage du boîtier tiroir par rapport au boîtier fourreau lorsque le boîtier tiroir est dans la seconde position.

On connaît le document US 7,175,470 décrivant un tel dispositif dans lequel la poignée peut prendre trois positions correspondant respectivement à une position de verrouillage, une position déverrouillée et une troisième position dans laquelle le boîtier tiroir est extrait du boîtier fourreau d'une certaine distance, position dans laquelle les éléments de connexion du boîtier fourreau sont déconnectés de ceux du boîtier tiroir.

Dans ce dispositif, la fonction est réalisée par un système du type à pêne de serrure et nécessite l'utilisation de plusieurs pièces rapportées à savoir un ressort, une came de blocage un pêne, etc... Pour connecter le produit, il est nécessaire d'exercer une pression sur la partie mobile pour la connecter, d'où un risque d'écrasement des contacts ou de mauvais raccordement, la poignée ne servant qu'à verrouiller ou extraire la partie mobile. Ainsi, la poignée peut être abaissée sans avoir la certitude que la connexion est bien réalisée, les pines de connecteurs pouvant être écrasés et les connecteurs mal embrochés.

La présente invention résout ces problèmes et propose un dispositif support extractible pour un équipement électrique, de conception simple, permettant en une seule manoeuvre de réaliser l'introduction, la connexion de manière fiable et précise, et le verrouillage du dispositif support extractible.

A cet effet la présente invention a pour objet un dispositif support extractible du genre précédemment mentionné, ce dispositif étant caractérisé en ce qu'il comporte un dispositif à crémaillère supporté en partie par la poignée et en partie par le boîtier fourreau et permettant le déplacement du boîtier tiroir par rapport au boîtier fourreau entre la première et seconde position précitées lorsque la poignée est entraînée de la première à la seconde position précitée.

Le fait d'utiliser un système à crémaillère permet de régler avec précision la cote d'embrochabilité des connecteurs qui se trouvent à l'intérieur du boîtier fourreau. Ceci permet également de fournir un effort progressif de connexion améliorant de ce fait la qualité de la connexion et la tenue dans le temps des connecteurs. Ceci est dû surtout à l'application d'un couple par une poignée en rotation, la composante de l'effort axial en résultant sur le tiroir étant croissante quand ladite poignée passe de la position débrochée à la position embrochée, cet effort étant maximal à la fin de l'embrochage afin de permettre un meilleur embrochage des connecteurs.

En outre, l'utilisation d'un dispositif à crémaillère permet la réalisation du dispositif de support en un minimum de pièces, lesquelles pouvant être réalisées par moulage.

Selon une caractéristique particulière, le dispositif à crémaillère précité comporte une première partie appartenant à la poignée comportant une partie dentée, ou bien une partie crénelée, placée aux deux extrémités de la poignée sensiblement suivant une portion de cercle autour des axes de rotation de la poignée, ladite première partie coopérant avec une seconde partie appartenant au boîtier fourreau comportant une partie crénelée, ou bien respectivement une partie dentée, de forme correspondante.

Selon une caractéristique particulière, les longueurs de la partie dentée et de la partie crénelée correspondante du dispositif à crémaillère correspondent à la course nécessaire pour que le déplacement de la poignée de la première à la seconde position permette de réaliser l'introduction complète du boîtier tiroir dans le boîtier fourreau, la connexion du(des) connecteur(s) dit(s) premier(s) avec le(s) connecteur(s) dit(s) second(s) et le verrouillage du boîtier tiroir sur le boîtier fourreau, et inversement pour que le déplacement de la poignée de la seconde à la première position permette de réaliser le déverrouillage du boîtier tiroir par rapport au boîtier fourreau, la déconnexion du(des) connecteur(s) dit(s) premier(s) d'avec le(s) connecteur(s) dit(s) second(s), et l'extraction du boîtier tiroir du boîtier fourreau.

Ainsi, l'on réalise l'introduction du boîtier tiroir, la connexion et le verrouillage au moyen d'une seule manoeuvre agissant progressivement sans discontinuité, ce qui concourt à l'obtention d'un positionnement précis des connecteurs les uns par rapport aux autres.

Selon une autre caractéristique, l'axe de rotation de la poignée s'étend verticalement lorsque le dispositif est en position de service.

Selon une autre caractéristique, ce dispositif comporte un système à glissière comportant au moins une rainure ou bien une nervure prévue sur la face extérieure de la partie supérieure du boîtier tiroir et/ou la face extérieure de la partie inférieure du boîtier tiroir, ces rainures et nervures étant destinées à coopérer avec au moins une nervure, ou bien respectivement au moins une rainure prévue sur la face intérieure de la partie supérieure ou la face intérieure de la partie inférieure du boîtier fourreau, ces rainures et nervures s'étendant sensiblement parallèlement à la direction de déplacement du boîtier tiroir par rapport au boîtier fourreau, et étant destinées à assurer le guidage du boîtier tiroir par rapport au boîtier fourreau lors de l'insertion du boîtier tiroir dans le boîtier fourreau jusqu'au verrouillage de ces deux boîtiers par les moyens de verrouillage précités.

Ainsi, grâce à la poignée et au guidage interne, on obtient un guidage du boitier tiroir dés l'introduction jusqu'au verrouillage, réalisant ainsi une prise en charge du tiroir pendant toute la course d'embrochage jusqu'au verrouillage, ce qui permet également d'obtenir une grande précision dans le positionnement des connecteurs.

Selon une autre caractéristique, ce dispositif comporte au moins une nervure longitudinale s'étendant sensiblement parallèlement à la direction de déplacement du boîtier tiroir par rapport au boîtier fourreau et prévue sur les faces intérieures de deux parois opposées du boîtier fourreau et/ou bien les faces extérieures de deux parois opposées du boîtier tiroir, lesdites nervures étant destinées à coopérer avec les faces lisses appartenant au boîtier tiroir et/ou au boîtier fourreau situées en regard desdites faces intérieures et extérieures, de manière à minimiser les surfaces de frottement entre le boîtier tiroir et le boîtier fourreau, un ajustement glissant étant réalisé entre les faces en regard des deux autres parois des deux boîtiers.

Selon une autre caractéristique, les moyens de verrouillage précités comportent une protubérance prévue sur la poignée apte à coopérer avec un orifice prévu dans une face latérale du boîtier tiroir lorsque la poignée est dans la seconde position correspondant à une position connectée des connecteurs des deux boîtiers, de manière à assurer le verrouillage en position de la poignée et en conséquence le verrouillage du boîtier tiroir par rapport au boîtier fourreau. Ce moyen de verrouillage permet également une réalisation par moulage.

Selon une autre caractéristique, ce dispositif comporte trois parties respectivement une première partie comportant un boîtier fourreau comportant une partie du dispositif à crémaillère, cette partie faisant partie intégrante du boîtier fourreau, une seconde partie comportant le boîtier tiroir et les deux axes d'articulation de la poignée sur le boîtier tiroir, lesdits axes étant venus de matière avec ledit boîtier tiroir, et une troisième partie comportant la poignée précitée, ladite poignée comportant la seconde partie du dispositif à crémaillère et à ses deux extrémités, un orifice destiné à recevoir ledit axe, ces trois parties étant réalisées par moulage.

Selon une caractéristique particulière, les parois supérieure et inférieure du boîtier fourreau comportent chacune une patte s'étendant à partir du bord libre desdites parois sensiblement parallèlement à la direction d'insertion du boîtier tiroir dans le boîtier fourreau, et en ce que la première partie du dispositif à crémaillère s'étend suivant une portion de cercle autour des axes de la poignée tandis que la seconde partie est supportée par les pattes précitées et s'étend linéairement parallèlement à la direction précitée.

Selon une autre caractéristique, la partie dentée précitée comporte une dent tandis que la partie crénelée précitée comporte un creux.

Selon une autre caractéristique, ces trois parties sont réalisées en un matériau plastique et/ou métallique.

Selon une autre caractéristique, le boîtier tiroir est un caisson supportant un relais électrique.

Mais d'autres avantages et caractéristiques de l'invention apparaîtront mieux dans la description détaillée qui suit et se réfère aux dessins annexés donnés uniquement à titre d'exemple et dans lesquels :
- La figure 1 est une vue en perspective illustrant le dispositif support extractible en position connectée et verrouillée,
- La figure 2 est une vue en perspective illustrant ce même dispositif dans une position intermédiaire entre la position illustrée sur la figure 1 et la position déconnectée et déverrouillée illustrée sur la figure 3, cette position correspondant à une position pas complètement débrochée (ou déconnectée) mais déverrouillée,
- La figure 3 est une vue en perspective illustrant ce dispositif dans une position déconnectée et déverrouillée,
- La figure 4 est une vue en perspective illustrant l'extraction complète de la partie mobile du dispositif,
- La figure 5 est une vue en perspective du dispositif support après extraction complète de la partie mobile,
- La figure 6 illustre plus particulièrement les connecteurs prévus sur la partie fixe et sur la partie mobile,
- Les figures 7,7a et 7b sont respectivement une vue en perspective, une vue en coupe et une vue partielle de la figure précédente, illustrant plus particulièrement le système de guidage de la partie mobile par rapport à la partie fixe du dispositif support, et

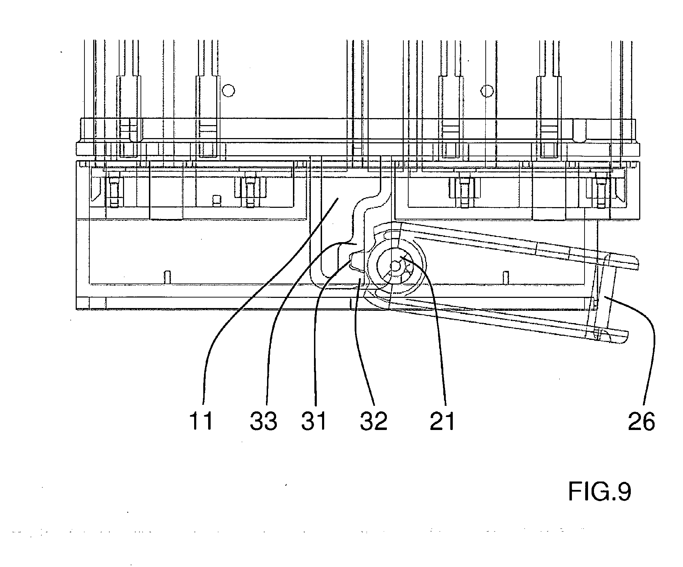

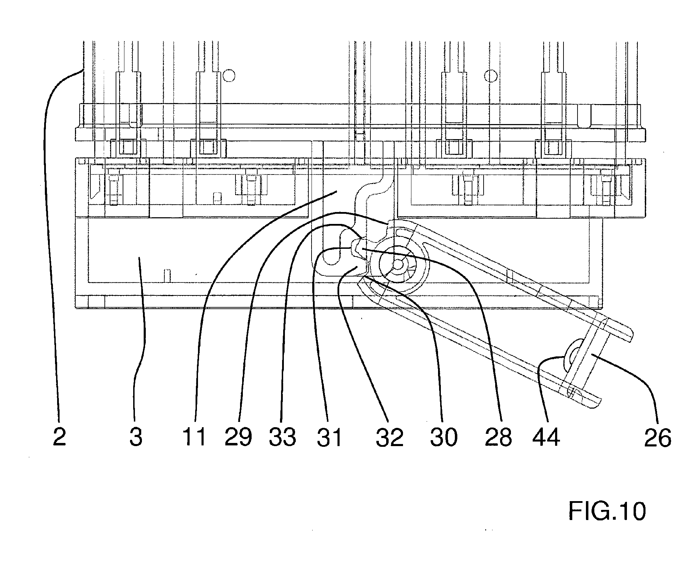

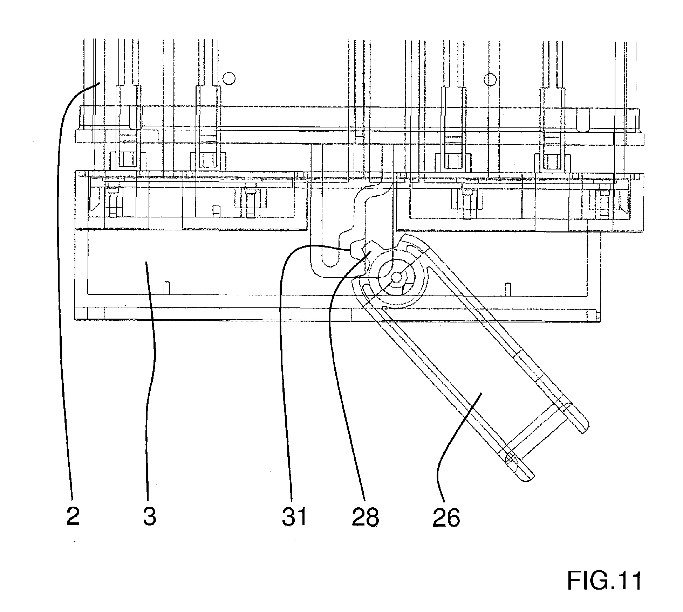

- Les figures 8, 9,10, 11 et 12 illustrent dans une vue partielle de dessus, la poignée du dispositif respectivement dans cinq positions allant de la position connectée et verrouillée à la position déconnectée et déverrouillée.

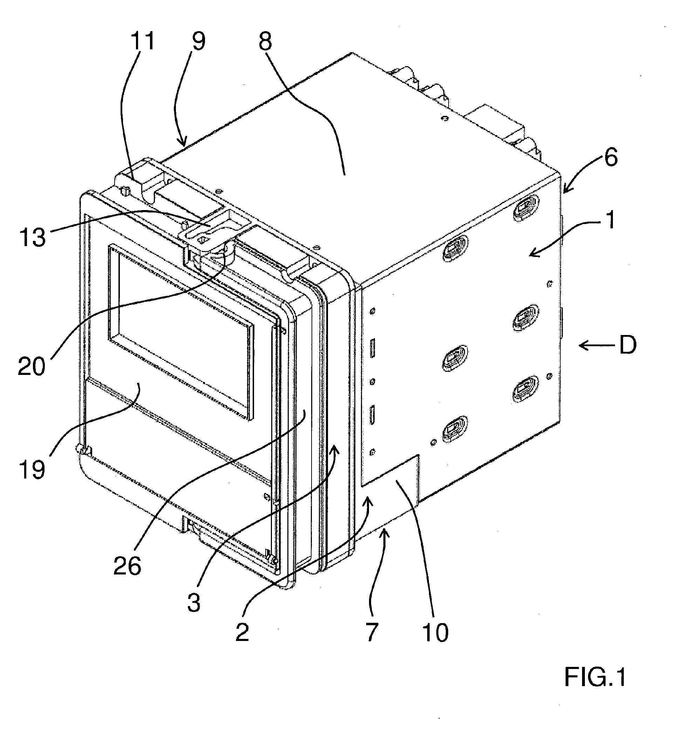

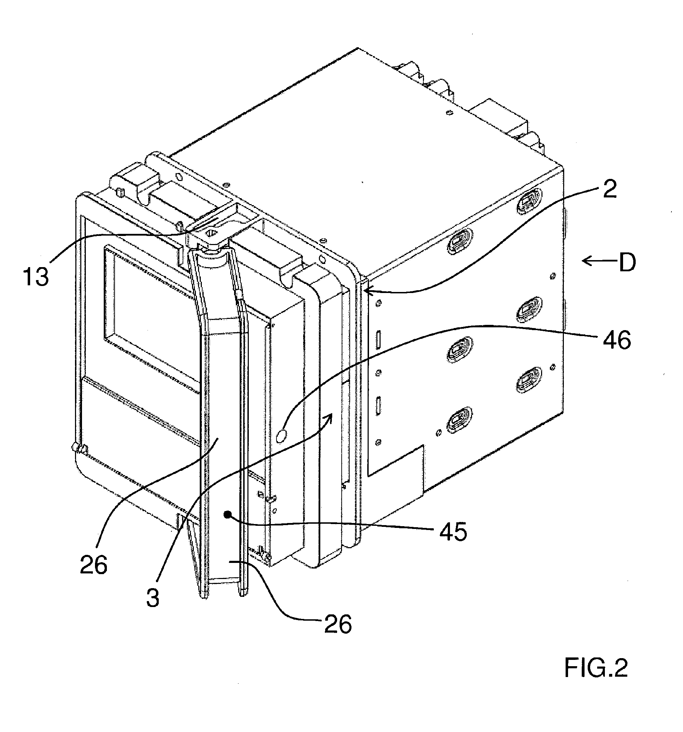

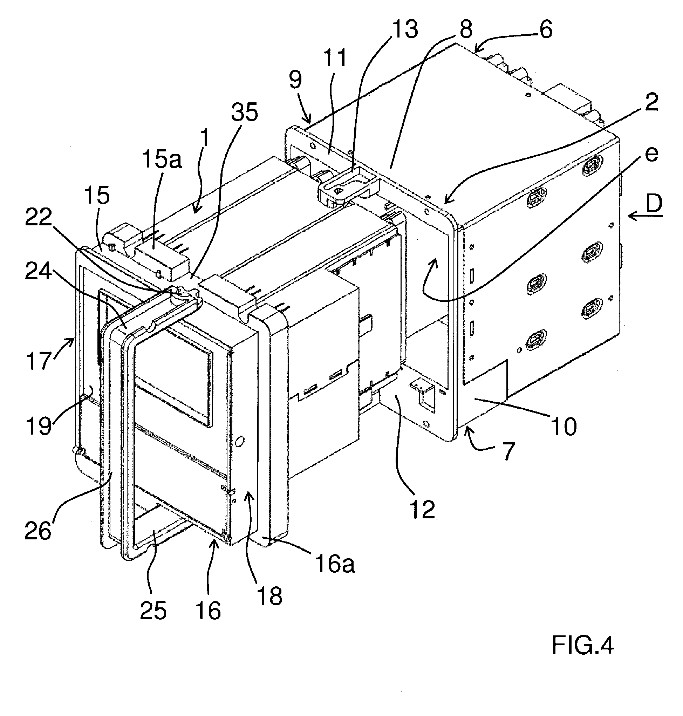

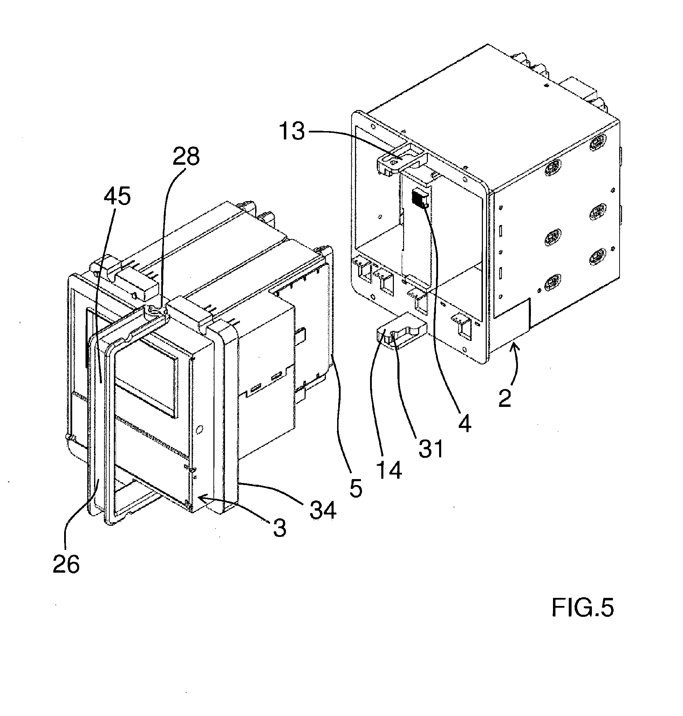

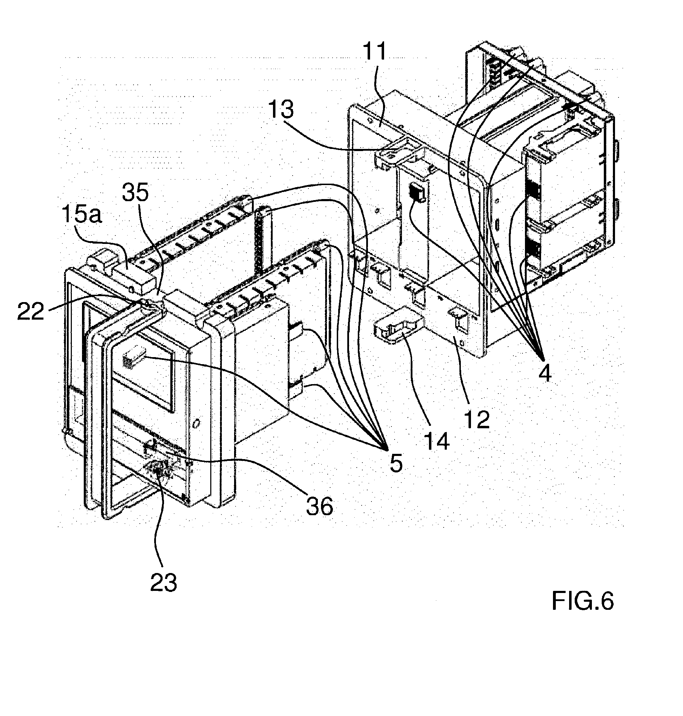

Sur les figures 1 à 6, un dispositif support D selon l'invention destiné à supporter un relais électrique 1 comporte une partie fixe constituée par un boîtier fourreau 2 destiné à être fixé sur une surface de support (non représentée) telle une étagère métallique ou autre, ledit boîtier fourreau 2 étant destiné à recevoir à coulissement une partie mobile constituée par un boîtier tiroir 3 supportant le relais électrique 1. Chacune de ces deux parties supporte des connecteurs, les connecteurs 4 du boîtier fourreau 2 étant destinés à être connectés par embrochage aux connecteurs 5 du boîtier tiroir 3 lors de l'introduction du boîtier tiroir dans le boîtier fourreau, tel que ceci est illustré sur les figures 5 et 6.

Ce boîtier fourreau 2 comporte un évidement de forme sensiblement parallélépipédique e délimité par une paroi inférieure 7, une paroi supérieure 8, deux parois latérales 9,10 et une paroi de fond 6, cet évidement e étant destiné à recevoir le boîtier tiroir 3 en particulier le relais 1. Les parois supérieure 8 et inférieure 7 de ce boîtier fourreau 2 comportent chacune, au niveau de leurs bords libres situés sur la face avant du boîtier fourreau, un rebord 11,12 en équerre dirigé vers l'extérieur du boîtier fourreau et comportant chacun une patte 13,14 s'étendant à partir desdits rebords parallèlement à la direction d'insertion du boîtier tiroir, chaque patte comportant une partie d'un dispositif à crémaillère.

Le boîtier tiroir 3 comporte également une paroi supérieure 15, une paroi inférieure 16, deux parois latérales 17,18 et une paroi formant une face avant 19. Ces deux parois respectivement supérieure 15 et inférieure 16 comportent chacune un axe 20,21 s'étendant vers l'extérieur du boîtier tiroir, lesdits axes étant destinés à être introduits respectivement dans deux orifices 22,23 prévus respectivement à l'une dite première des extrémités de deux bras 24,25 appartenant à une poignée 26, lesdits axes formant l'axe d'articulation de la poignée, ladite poignée étant mobile en rotation entre une première position dans laquelle elle s'étend dans un plan sensiblement perpendiculaire au plan de la face avant 19 du boîtier tiroir (3) et une seconde position dans laquelle elle s'étend dans un plan sensiblement parallèle à ladite face.

A cette même première extrémité, ces bras 24,25 comportent également une partie dentée placée autour de l'orifice 22,23 correspondant, chaque partie dentée comportant une dent 28 entourée de deux parties évidées 29,30, cette partie dentée constituant la deuxième partie du dispositif à crémaillère précité, ladite dent 28 étant destinée à coopérer avec la première partie crènelée précitée constituée d' un creux 31 entourée de deux proéminences 32,33 appartenant aux pattes précitées 13,14, lesdites pattes étant situées en regard desdites extrémités des bras lorsque le boîtier tiroir 3 est partiellement introduit dans le boîtier fourreau 2.

Les parties dentées 28, 29, 30 associées à la poignée 26 s'étendent suivant une portion de cercle autour des axes 20,21 de la poignée, tandis que les parties crénelées 31, 32, 33 associées aux pattes 13,14 s'étendent linéairement. Chacune des parois supérieure 15, inférieure 16 et latérales 17,18 de ce boîtier tiroir 3 comporte un rebord 15a, 16a, 17a, 18a s'étendant perpendiculairement auxdites parois, l'ensemble de ces rebords formant un cadre 34 autour dudit boîtier tiroir 3.

Dans les deux rebords 15a, 16a s'étendant respectivement à partir des deux bords libres des parois supérieure 15 et inférieure 16 du boîtier tiroir 3 sont prévues respectivement deux ouvertures 35,36 destinées à permettre le passage des deux pattes précités 13,14 afin que les dents 28 associées à la poignée 26 puissent coopérer avec les creux 31 des deux pattes 13,14, de la manière qui sera décrite dans ce qui suit.

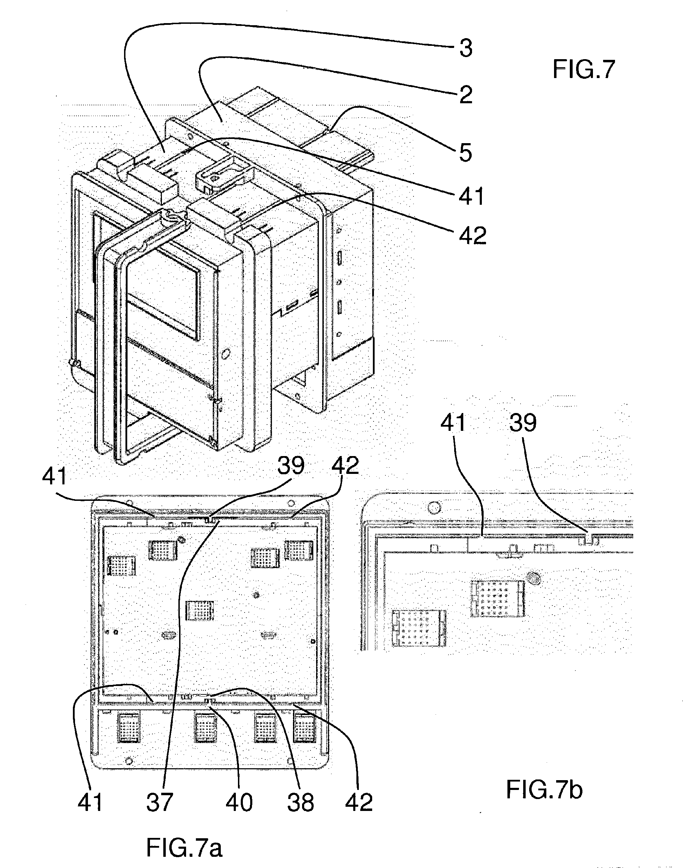

Tel qu'illustré plus particulièrement sur les figures 7,7a, et 7b, ce boîtier tiroir 3 comporte également sur la face extérieure de ses parois supérieure 15 et inférieure 16, respectivement deux rainures 37,38 s'étendant parallèlement à la direction d'insertion du boîtier tiroir dans le boîtier fourreau et destinées à coopérer avec une nervure de forme correspondante 39,40 prévue sur la face intérieure du boîtier fourreau située en regard desdites rainures, de manière à permettre le guidage en translation du boîtier tiroir par rapport au boîtier fourreau. Ce boîtier tiroir 3 comporte également sur la face extérieure de la paroi inférieure 16 et de la paroi supérieure 15, et situées de part et d'autre des rainures précitées 37,38, deux nervures 41,42 destinées à coopérer avec les faces lisses situées en regard du boîtier fourreau 2, de manière à réduire le frottement entre le boîtier tiroir et le boîtier fourreau lors du déplacement du boîtier tiroir par rapport au boîtier fourreau.

Ce dispositif support selon l'invention comporte également des moyens de verrouillage du boîtier tiroir 3 sur le boîtier fourreau 2, ces moyens comportant dans cette réalisation particulière décrite, une protubérance 44 prévue sur la face intérieure de la branche 45 de la poignée 26 reliant les deux bras 24,25, cette protubérance 44 étant destinée à coopérer avec un orifice 46 prévu dans une face latérale 17 du boîtier tiroir 3 le long de laquelle la poignée 21 est rabattue en position verrouillée, ladite protubérance venant s'intercaler entre la poignée 26 et ledit orifice, de manière à retenir la poignée dans cette position, ceci constituant un encliquetage par déformation élastique de la partie 45 de la poignée 26.

On notera également que ces moyens de verrouillage peuvent être complétés avantageusement par un second verrouillage par plombage prévu sur la poignée.

Le fonctionnement du dispositif selon l'invention va être décrit dans ce qui suit en référence aux figures.

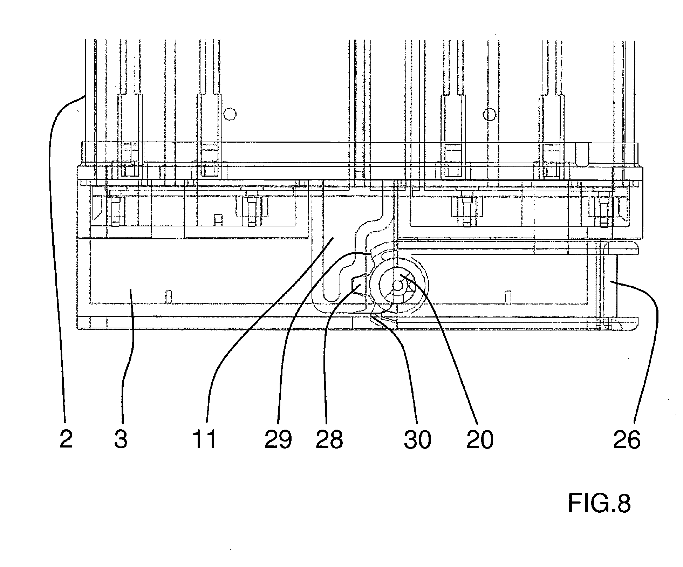

Sur les figures 1 et 8, le dispositif support D est dans une position connectée et verrouillée, le dispositif de verrouillage étant actif, la poignée 26 s'étendant dans le plan de la face avant du dispositif, la dent 28 associée aux poignées étant totalement logées dans les creux 31 des pattes 13,14 du boîtier fourreau, et les rebords 15a,16a du boîtier tiroir 3 étant en appui sur les rebords 11,12 situés en regard du boîtier fourreau 2.

Dans cette position, les connecteurs 5 du boîtier tiroir 3 sont embrochés sur les connecteurs 4 du boîtier fourreau 2.

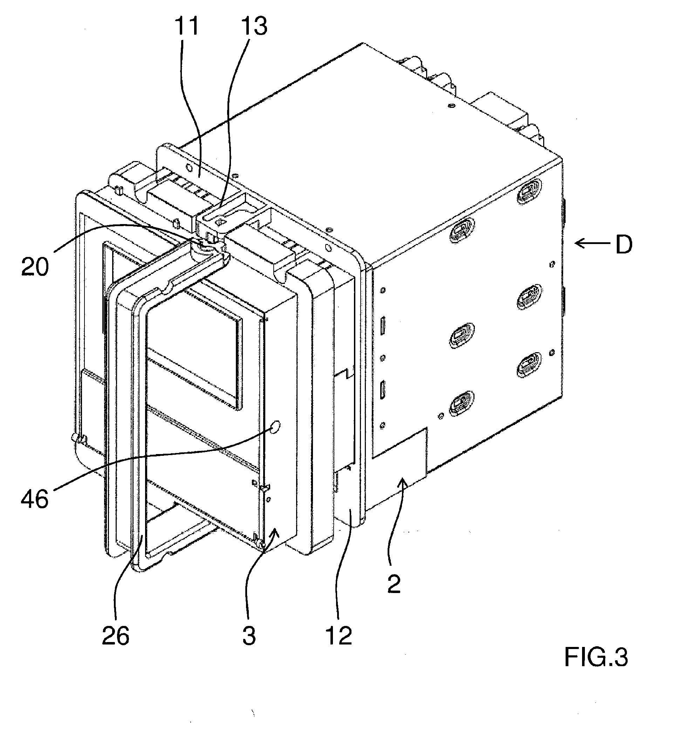

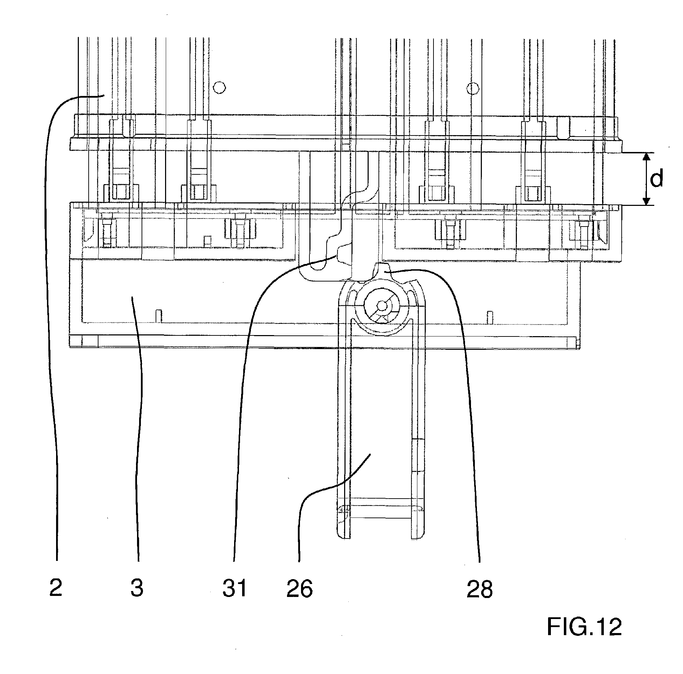

Lorsque l'on souhaite réaliser la déconnexion de ces connecteurs 4,5, la poignée 26 est actionnée de la droite vers le centre de manière à passer d'une position illustrée sur les figures 1 et 8, à une position illustrée sur les figures 3 et 12.

Lors de ce déplacement de la poignée, le dispositif de verrouillage est tout d'abord désactivé, la protubérance 44 étant dégagée de l'orifice 46 lors de la rotation de la poignée, et les dents 28 associées à la poignée 26 coopèrent avec les creux 31 du boîtier fourreau 2 de manière à séparer progressivement le boîtier tiroir du boîtier fourreau jusqu'à une certaine distance de séparation d entre les deux boîtiers.

Cette distance d correspond à la course de déverrouillage et de déconnexion ou bien à la course de connexion/ verrouillage, de sorte que lorsque l'on arrive à cette distance de séparation, les connecteurs 5 du boîtier tiroir 3 sont déconnectés de ceux 4 du boîtier fourreau 2.

Lors d'une manoeuvre de connexion, pendant toute la course en translation du boîtier tiroir 3, du début de son introduction dans le boîtier fourreau 2 jusqu'à son verrouillage, le boîtier tiroir est guidé en translation par les rainures 37,38 coopérant avec les nervures 39,40 de manière à assurer son positionnement précis tout au long de son déplacement et garantir que les connecteurs sont embrochés correctement sur une course précise.

Pendant, ce déplacement également, les nervures 41,42 du boîtier tiroir 3 coopèrent avec les faces lisses en regard du boîtier fourreau 2 de manière à minimiser les frottements.

La manoeuvre destinée à réaliser la connexion ne sera pas décrite car elle correspond à la manoeuvre inverse de celle décrite précédemment et nécessite cette fois le déplacement de la poignée du centre vers la droite, de manière à passer de la position illustrée sur les figures 3 et 12 à la position illustrée sur les figures 1 et 8.

On a donc réalisé selon l'invention un dispositif support extractible de mise en oeuvre aisée, une seule action étant nécessaire pour réaliser la connexion ou la déconnexion du dispositif.

Ce dispositif est également facile à réaliser industriellement et ne nécessite pas de rajouter des pièces ou accessoires supplémentaires pour réaliser sa fonction. L'invention a permis de regrouper en un seul mécanisme les trois fonctions à savoir l'insertion finale du boîtier tiroir, l'embrochage des connexions et le verrouillage en position embrochée du boîtier tiroir.

On notera que cette insertion peut se faire à l'aide d'une seule main grâce à la poignée qui permet aussi le portage et la mise en position préalable du tiroir avant l'embrochage.

Il n'y a pas non plus de risque, d'oubli lors du montage du dispositif de pièces rapportées.

Ce dispositif supprime également les risques de non connexion du produit.

En effet, la connexion est assurée par la rotation de la poignée qui représente exactement la cote d'embrochabilité des connecteurs qui se trouvent au fond du boîtier fourreau. Un guidage par glissière est assuré dans la partie mobile, lequel est complété par les conducteurs au fond du boîtier fourreau, de sorte que le tiroir est pris en charge pendant toute la course d'embrochage jusqu'au verrouillage. En outre, la connexion n'est pas possible si la poignée est en position fermée sur la partie mobile et que le boîtier tiroir n'est pas connecté, ce qui évite un mauvais embrochage et un endommagement des contacts. En effet, si la poignée est en position fermée et le dispositif non connecté, il est nécessaire pour réaliser cette connexion de ramener la partie mobile en position d'extraction et la poignée dans la première position de manière à réintroduire le bloc tiroir correctement afin que celui-ci soit pris en charge par les moyens de guidage, dés son introduction.

En conséquence, si le produit n'est pas connecté, le boîtier tiroir reste désolidarisé du boîtier fourreau, ne laissant ainsi aucune ambiguïté sur la non connexion et par la même occasion empêchant toute détérioration possible des contacts. En effet, cette position interdit toute possibilité de contact au niveau des connecteurs.

Les deux boîtiers sont réalisés avantageusement en deux matériaux complémentaires en polymère.

Le guidage du boîtier tiroir par rapport au boîtier fourreau est réalisé sur les deux faces haute et basse du boîtier tiroir. Il sera également possible de choisir des matériaux plastique ou mixte (plastique et métal) permettant de minimiser les efforts de frottement.

Le dimensionnement des dents du système crémaillère a été optimisé pour représenter la course optimale nécessaire pour l'insertion finale comprenant l'embrochage et le verrouillage de la partie mobile sur la partie fixe et les jeux nécessaires.

Bien entendu, l'invention n'est pas limitée au mode de réalisation décrit et illustré qui n'a été donné qu'à titre d'exemple.

C'est ainsi que la disposition des dents et des parties en creux sur la poignée ou sur le boîtier fourreau pourra être inversée.

De même, la poignée pourrait se déplacer du centre vers la gauche, contrairement au mode de réalisation illustré qui décrit un déplacement de la poignée du centre vers la droite.

Une autre possibilité pourrait également consister à utiliser un axe d'articulation de la poignée, horizontal au lieu d'un axe vertical, tel que dans la réalisation illustrée précédemment. Cette réalisation serait cependant moins avantageuse car cette poignée ne pourrait plus porter à elle seule le boîtier tiroir jusqu'au boîtier fourreau, ce qui nécessiterait l'utilisation d'une seconde main.

On pourra également citer la possibilité d'utiliser deux poignées pour des tiroirs larges ou lourds, lesquelles pourront ainsi être tenues à deux mains, l'une des poignées se déplaçant du centre vers la gauche, alors que l'autre des poignées se déplace du centre vers la droite, lesquelles poignées seront judicieusement placées par rapport aux connecteurs.

Au contraire, l'invention comprend tous les équivalents techniques des moyens décrits ainsi que leurs combinaisons si celles-ci sont réalisées suivant son esprit.

## Revendications

1. Dispositif support extractible pour équipement électrique comprenant un boîtier tiroir comportant au moins un connecteur dit premier, ledit boîtier tiroir étant destiné à s'insérer dans un boîtier fourreau comportant au moins un connecteur dit second, de manière à réaliser la connexion entre le ou les connecteur(s) dit(s) premier(s) et le ou les connecteur(s) dit(s) second(s), ledit boîtier tiroir étant muni d'une poignée ayant deux bras montés chacun à rotation autour d'un axe, lesdits bras pouvant occuper ensemble une première position dans laquelle ils s'étendent sensiblement perpendiculairement à une face du boîtier tiroir et une seconde position dans laquelle ces deux bras s'étendent dans un plan sensiblement parallèle à ladite face, ledit boîtier tiroir étant mobile par rapport au boîtier fourreau entre une première position dans laquelle ledit boîtier tiroir est extrait au moins en partie du boîtier fourreau, la poignée est dans la première position précitée, et les connecteurs dits premiers sont déconnectés des connecteurs dits seconds, et une seconde position dans laquelle le boîtier tiroir est complètement introduit à l'intérieur du boîtier fourreau, la poignée est dans la seconde position précitée et le ou les connecteur(s) dit premier(s) est(sont) connecté(s) au(x) connecteur(s) dit(s) second(s), et des moyens de verrouillage du boîtier tiroir par rapport au boîtier fourreau lorsque le boîtier tiroir est dans la seconde position, le dispositif comportant un dispositif à crémaillère (28,29,30,31,32,33) supporté en partie par la poignée (26) et en partie par le boîtier fourreau (2) et permettant le déplacement du boîtier tiroir (3) par rapport au boîtier fourreau (2) entre la première et la seconde position précitées lorsque la poignée (26) est entraînée de la première à la seconde position précitée, **caractérisé en ce que** le dispositif à crémaillère précité comporte une première partie appartenant à la poignée (26) et comportant une partie dentée (28,29,30), ou bien une partie crénelée (31,32,33), placée aux deux extrémités de la poignée, sensiblement suivant une portion de cercle autour des axes (20,21) de rotation de la poignée (26), ladite première partie coopérant avec une seconde partie appartenant au boîtier fourreau (2) et comportant une partie crénelée (31,32,33), ou bien respectivement une partie dentée (28,29,30), de forme correspondante, et **en ce que** les parois supérieure (8) et inférieure (7) du boîtier fourreau (2) comportent chacune une patte (13,14) s'étendant à partir du bord libre desdites parois sensiblement parallèlement à la direction d'insertion du boîtier tiroir dans le boîtier fourreau, et **en ce que** la première partie du dispositif à crémaillère s'étend suivant une portion de cercle autour des axes (20,21) de la poignée tandis que la seconde partie est supportée par les pattes précitées (13,14) et s'étend linéairement parallèlement à la direction précitée.

2. Dispositif support extractible selon la revendication 1, **caractérisé en ce que** les longueurs de la partie dentée (28,29,30) et de la partie crénelée (31,32,33) correspondante du dispositif à crémaillère correspondent à la course nécessaire pour que le déplacement de la poignée (26) de la première à la seconde position permette de réaliser l'introduction complète du boîtier tiroir (3) dans le boîtier fourreau (2), la connexion du(des) connecteur(s) dit(s) premier(s) (4) avec le(s) connecteur(s) dit(s) second(s) (5) et le verrouillage du boîtier tiroir (3) sur le boîtier fourreau (2), et inversement, pour que le déplacement de la poignée (26) de la seconde position à la première position permette de réaliser le déverrouillage du boîtier tiroir (3), la déconnexion des connecteurs dits premiers (4) des connecteurs dits seconds (5), et l'extraction du boîtier tiroir du boîtier fourreau.

3. Dispositif support extractible selon la revendication 1 ou 2, **caractérisé en ce que** l'axe de rotation de la poignée (26) s'étend verticalement lorsque le dispositif est en position de service.

4. Dispositif support extractible selon l'une quelconque des revendications précédentes, **caractérisé en ce qu'**il comporte un système à glissière comportant au moins une rainure (37,38) ou bien une nervure (39,40) prévue sur la face extérieure de la paroi supérieure (15) du boîtier tiroir (3) et la face extérieure de la paroi inférieure (16) du boîtier tiroir (3), ces rainures (37,38) et nervures (39,40) étant destinées à coopérer avec au moins une nervure (39,40), ou bien respectivement au moins une rainure (37,38), prévue sur la face intérieure de la paroi supérieure (8) ou la face intérieure de la paroi inférieure (7) du boîtier fourreau (2), ces rainures et nervures s'étendant sensiblement parallèlement à la direction de déplacement du boîtier tiroir par rapport au boîtier fourreau, et étant destinées à assurer le guidage du boîtier tiroir par rapport au boîtier fourreau lors de l'insertion du boîtier tiroir dans le boîtier fourreau jusqu'au verrouillage de ces deux boîtiers par les moyens de verrouillage précités.

5. Dispositif support extractible selon l'une quelconque des revendications précédentes, **caractérisé en ce qu'**il comporte au moins une nervure longitudinale (41,42) s'étendant sensiblement parallèlement à la direction de déplacement du boîtier tiroir par rapport au boîtier fourreau et prévue(s) sur les faces intérieures de deux parois opposées (7,8) du boîtier fourreau (2) et/ou bien les faces extérieures de deux parois opposées (15,16) du boîtier tiroir (3), lesdites nervures étant destinées à coopérer avec les faces lisses appartenant au boîtier tiroir et/ou au boîtier fourreau situées en regard desdites faces intérieures et extérieures, de manière à minimiser les surfaces de frottement entre le boîtier tiroir et le boîtier fourreau, un ajustement glissant étant réalisé entre les faces en regard des deux autres parois des deux boîtiers.

6. Dispositif support extractible selon l'une quelconque des revendications 1 à 5, **caractérisé en ce que** les moyens de verrouillage précités comportent une protubérance (44) prévue sur la poignée (26) apte à coopérer avec un orifice (46) prévu dans une face latérale du boîtier tiroir (3) lorsque la poignée est dans la seconde position correspondant à une position connectée des connecteurs des deux boîtiers, de manière à assurer le verrouillage en position de la poignée et en conséquence le verrouillage du boîtier tiroir par rapport au boîtier fourreau.

7. Dispositif support extractible selon l'une quelconque des revendications précédentes, **caractérisé en ce que** ce dispositif comporte trois parties respectivement une première partie comportant un boîtier fourreau (2) comportant une partie du dispositif à crémaillère, cette partie faisant partie intégrante du boîtier fourreau, une seconde partie comportant le boîtier tiroir (3) et les deux axes (20,21) d'articulation de la poignée sur le boîtier tiroir, lesdits axes étant venus de matière avec ledit boîtier tiroir, et une troisième partie comportant la poignée précitée, ladite poignée (26) comportant la seconde partie du dispositif à crémaillère et, à ses deux extrémités, un orifice (22,23) destiné à recevoir ledit axe, ces trois parties étant réalisées par moulage.

8. Dispositif support extractible selon l'une quelconque des revendications 1 à 7, **caractérisé en ce que** les parois supérieure (8) et inférieure (7) du boîtier fourreau (2) comportent chacune une patte (13,14) s'étendant à partir du bord libre desdites parois sensiblement parallèlement à la direction d'insertion du boîtier tiroir dans le boîtier fourreau, et **en ce que** la première partie du dispositif à crémaillère s'étend suivant une portion de cercle autour des axes (20,21) de la poignée tandis que la seconde partie est supportée par les pattes précitées (13,14) et s'étend linéairement parallèlement à la direction précitée.

9. Dispositif support extractible selon la revendication 1, **caractérisée en ce que** la partie dentée précitée comporte une dent (28), tandis que la partie crénelée précitée comporte un creux (31) de forme correspondante.

10. Dispositif support extractible selon la revendication 7, **caractérisé en ce que** ces trois parties sont réalisées en un matériau plastique et/ou métallique.

11. Dispositif support extractible selon l'une quelconque des revendications précédentes, **caractérisé en ce que** le boîtier tiroir (3) est un caisson supportant un relais électrique (1).

## Patentansprüche

1. Einschubträger für eine elektrische Ausrüstung, umfassend ein Einschubgehäuse mit mindestens einem sogenannten ersten Steckverbinder, welches Einschubgehäuse dazu dient, in ein Gehäusechassis mit mindestens einem sogenannten zweiten Steckverbinder eingefahren zu werden, derart, dass eine Verbindung zwischen dem/den sogenannten ersten Steckverbinder/n und dem/ den sogenannten zweiten Steckverbinder/n hergestellt wird, wobei das Einschubgehäuse einen Handgriff mit zwei um jeweils eine Achse verschwenkbaren Armen, welche Arme zusammen eine erste Stellung, in der sie annähernd senkrecht zu einer Seite des Einschubgehäuses stehen, und eine zweite Stellung einnehmen können, in der diese beiden Arme in einer annähernd parallel zur genannten Seite liegenden Ebene angeordnet sind, wobei das genannte Einschubgehäuse relativ zum Gehäusechassis zwischen einer ersten Stellung, in der das Einschubgehäuse zumindest teilweise aus dem Gehäusechassis herausgefahren ist, der Handgriff in der genannten ersten Stellung steht und die sogenannten ersten Steckverbinder von den sogenannten zweiten Steckverbindern getrennt sind, und einer zweiten Stellung verschoben werden kann, in der das Einschubgehäuse vollständig in das Gehäusechassis eingefahren ist, der Handgriff in der genannten zweiten Stellung steht und der genannte erste Steckverbinder mit dem genannten zweiten Steckverbinder verbunden ist bzw. die genannten ersten Steckverbinder mit den genannten zweiten Steckverbindern verbunden sind, sowie Verriegelungsmittel umfasst, die dazu dienen, das Einschubgehäuse im Gehäusechassis zu verriegeln, wenn sich das Einschubgehäuse in der zweiten Stellung befindet, welcher Einschubträger ein Verzahnungssystem (28, 29, 30, 31, 32, 33) umfasst, das teilweise am Handgriff (26) und teilweise am Gehäusechassis (2) ausgebildet ist und mit dessen Hilfe das Einschubgehäuse (3) relativ zum Gehäusechassis (2) zwischen der genannten ersten Stellung und der genannten zweiten Stellung verschoben werden kann, wenn der Handgriff (26) von der genannten ersten Stellung in die genannte zweite Stellung verbracht wird, **dadurch gekennzeichnet, dass** das genannte Verzahnungssystem einen zum Handgriff (26) gehörenden ersten Teil, der einen an den beiden Enden des Handgriffs, annähernd in Form eines um die Drehachsen (20, 21) des Handgriffs (26) verlaufenden Kreisbogens ausgebildeten verzahnten Bereich (28, 29, 30) bzw. gekerbten Bereich (31, 32, 33) umfasst, welcher erste Teil mit einem zum Gehäusechassis (2) gehörenden zweiten Teil angepasster Form zusammenwirkt, der einen gekerbten Bereich (31, 32, 33) bzw. einen verzahnten Bereich (28, 29, 30) umfasst, dadurch, dass an der oberen Wand (8) und an der unteren Wand (7) des Einschubgehäuses (2) jeweils eine Zunge (13, 14) ausgebildet ist, die sich vom freien Rand der genannten Wände annähernd parallel zur Einschubrichtung des Einschubgehäuses in das Gehäusechassis erstreckt, sowie dadurch, dass der erste Teil des Verzahnungssystems in Form eines um die Achsen (20, 21) des Handgriffs verlaufenden Kreisbogens ausgebildet ist, während der zweite Teil an den genannten Zungen (13, 14) ausgebildet ist und sich geradlinig, parallel zu der genannten Richtung erstreckt.

2. Einschubträger nach Anspruch 1, **dadurch gekennzeichnet, dass** die Länge des verzahnten Bereichs (28, 29, 30) und des zugeordneten gekerbten Bereichs (31, 32, 33) des Verzahnungssystems dem Hub entspricht, der erforderlich ist, damit die Überführung des Handgriffs (26) von der ersten in die zweite Stellung ein vollständiges Einfahren des Einschubgehäuses (3) in das Gehäusechassis (2), die Verbindung des sogenannten ersten Steckverbinders/der sogenannten ersten Steckverbinder (4) mit dem sogenannten zweiten Steckverbinder/den sogenannten zweiten Steckverbindern (5) sowie die Verriegelung des Einschubgehäuses (3) im Gehäusechassis (2) bzw. umgekehrt die Überführung des Handgriffs (26) von der zweiten Stellung in die erste Stellung die Entriegelung des Einschubgehäuses (3), die Trennung der genannten ersten Steckverbinder (4) von den genannten zweiten Steckverbindern (5) und das Herausfahren des Einschubgehäuses aus dem Gehäusechassis erlaubt.

3. Einschubträger nach Anspruch 1 oder 2, **dadurch gekennzeichnet, dass** die Drehachse des Handgriffs (26) in der Betriebsstellung des Trägers senkrecht angeordnet ist.

4. Einschubträger nach irgendeinem der vorhergehenden Ansprüche, **dadurch gekennzeichnet, dass** er ein Gleitsystem mit mindestens einer an der Außenseite der oberen Wand (15) sowie an der Außenseite der unteren Wand (16) des Einschubgehäuses (3) ausgebildeten Rippe (39, 40) bzw. Nut (37, 38) umfasst, welche Nuten (37, 38) bzw. Rippen (39, 40) dazu dienen, mit mindestens einer an der Innenseite der oberen Wand (8) bzw. an der Innenseite der unteren Wand (7) des Gehäusechassis (3) ausgebildeten Rippe (39, 40) bzw. Nut (37, 38) zusammenzuwirken, wobei die genannten Nuten und Rippen annähernd parallel zur Verschiebungsrichtung des Einschubgehäuses in Bezug zum Gehäusechassis angeordnet sind und dazu dienen, beim Einfahren des Einschubgehäuses in das Gehäusechassis die Führung des Einschubgehäuses im Gehäusechassis bis zur Verriegelung der beiden Teile durch die genannten Verriegelungsmittel zu gewährleisten.

5. Einschubträger nach irgendeinem der vorhergehenden Ansprüche, **dadurch gekennzeichnet, dass** er mindestens eine Längsrippe (41, 42) umfasst, die annähernd parallel zur Verschiebungsrichtung des Einschubgehäuses in Bezug zum Gehäusechassis angeordnet und an den Innenseiten der beiden einander gegenüber liegenden Wände (7, 8) des Einschubgehäuses (2) und/oder den Außenseiten der beiden einander gegenüberliegenden Wände (15, 16) des Gehäusechassis (3) ausgebildet sind, welche Längsrippen dazu dienen, mit den diesen genannten Innen- und Außenseiten gegenüber liegenden glatten Seiten des Einschubgehäuses und/oder des Gehäusechassis' zusammenzuwirken, derart, dass die Reibungsflächen zwischen dem Einschubgehäuse und dem Gehäusechassis minimiert wirden, wobei zwischen den einander gegenüber liegenden Seiten der zwei anderen Wände der beiden Trägerteile eine Gleitführung erfolgt.

6. Einschubträger nach irgendeinem der Ansprüche 1 bis 5, **dadurch gekennzeichnet, dass** die genannten Verriegelungsmittel einen am Handgriff (26) ausgebildeten Vorsprung (44) umfassen, der dazu dient, mit einer, in einer Seitenwand des Einschubgehäuses (3) ausgebildeten Öffnung (46) zusammenzuwirken, wenn sich der Handgriff in der zweiten Stellung entsprechend einer Verbindungsstellung der Steckverbinder der beiden Trägerteile befindet, derart, dass die Verriegelung des Handgriffs in seiner Stellung und damit die Verriegelung des Einschubgehäuses im Gehäusechassis gewährleistet ist.

7. Einschubträger nach irgendeinem der vorhergehenden Ansprüche, **dadurch gekennzeichnet, dass** er drei Teile umfasst, und zwar einen ersten Teil mit einem Gehäusechassis (2), das als integralen Bestandteil einen Teil des Verzahnungssystems umfasst, einen zweiten Teil mit dem Einschubgehäuse (3) und den beiden Drehachsen (20, 21) zum Verschwenken des Handgriffs am Einschubgehäuse, welche Achsen an das genannte Einschubgehäuse angeformt sind, sowie einen dritten Teil mit dem genannten Handgriff, welcher Handgriff (26) den zweiten Teil der Verzahnung sowie an seinen Enden jeweils eine Öffnung (22, 23) zur Aufnahme der genannten Achse umfasst, wobei alle drei Teile des Trägers als Kunststoff-Formteile ausgebildet sind.

8. Einschubträger nach irgendeinem der Ansprüche 1 bis 7, **dadurch gekennzeichnet, dass** in der oberen Wand (8) und in der unteren Wand (7) des Einschubgehäuses (2) jeweils eine Zunge (13, 14) ausgebildet ist, die sich vom freien Rand der genannten Wände annähernd parallel zur Einschubrichtung des Einschubgehäuses in das Gehäusechassis erstreckt, und dadurch, dass der erste Teil der Verzahnung in Form eines um die Achsen (20, 21) des Handgriffs verlaufenden Kreisbogens ausgebildet ist, während der zweite Teil an den genannten Zungen (13, 14) ausgebildet ist und sich geradlinig, parallel zu der genannten Richtung erstreckt

9. Einschubträger nach Anspruch 1, **dadurch gekennzeichnet, dass** der genannte verzahnte Bereich einen Zahn (28) umfasst, während der genannte gekerbte Bereich eine entsprechend geformte Vertiefung (31) umfasst.

10. Einschubträger nach Anspruch 7, **dadurch gekennzeichnet, dass** die drei Teile aus Kunststoff und/oder Metall bestehen.

11. Einschubträger nach irgendeinem der vorhergehenden Ansprüche, **dadurch gekennzeichnet, dass** das Einschubgehäuse (3) als Kasten mit einem darin installierten elektrischen Relais ausgebildet ist.

## Claims

1. An extractable support device for an electric equipment unit comprising a slide-mounted plug-in unit comprising at least one connector called first connector, said plug-in unit being designed to be inserted in a housing case comprising at least one connector called second connector so as to perform connection between the connector or connectors called first connector(s) and the connector or connectors called second connector(s), said plug-in unit being provided with a handle having two arms each fitted rotating around a pivot-pin, said arms being able to occupy together a first position in which they extend substantially perpendicularly to one surface of the plug-in unit and a second position in which these two arms extend in a plane substantially parallel to said surface, said plug-in unit being movable with respect to the housing case between a first position in which said plug-in unit is at least partially extracted from the housing case, the handle is in the above-mentioned first position, and the connectors called first connectors are disconnected from the connectors called second connectors, and a second position in which the plug-in unit is completely inserted inside the housing case, the handle is in the above-mentioned second position, and the connector(s) called first connector(s) is(are) connected to the connector(s) called second connector(s), and means for locking the plug-in unit with respect to the housing case when the plug-in unit is in the second position, the device comprising a rack device (28,29,30,31,32,33) supported partly by the handle (26) and partly by the housing case (2) and enabling movement of the plug-in unit (3) with respect to the housing case (2) between the above-mentioned first and second positions when the handle (26) is moved from the above-mentioned first position to the above-mentioned second position, **characterized in that** the above-mentioned rack device comprises a first part belonging to the handle (26) and comprising a toothed part (28,29,30), or a crenelated part (31,32,33), placed at the two ends of the handle substantially in the form of a portion of a circle around the pivot-pins (20,21) of the handle (26), said first part collaborating with a second part belonging to the housing case (2) and comprising a crenelated part (31,32,33), or respectively a toothed part (28,29,30), of corresponding shape, and **in that** the top panel (8) and bottom panel (7) of the housing case (2) each comprise a lug (13,14) extending from the free edge of said panels in substantially parallel manner to the direction of insertion of the plug-in unit in the housing case, and **in that** the first part of the rack device extends in the form of a portion of a circle around the pivot-pins (20,21) of the handle whereas the second part is supported by the above-mentioned lugs (13,14) and extends linearly in parallel manner to the above-mentioned direction.

2. The extractable support device according to claim 1, **characterized in that** the lengths of the toothed part (28,29,30) and of the corresponding crenelated part (31,32,33) of the rack device correspond to the travel necessary for movement of the handle (26) from the first to the second position to enable complete insertion of the plug-in unit (3) in the housing case (2), connection of the connector(s) called first connector(s) (4) with the connector(s) called second connector(s) (5) and locking of the plug-in unit (3) on the housing case (2), and inversely for movement of the handle (26) from the second to the first position to enable unlocking of the plug-in unit (3), disconnection of the connector(s) called first connector(s) (4) from the connector(s) called second connector(s) (5) and extraction of the plug-in unit from the housing case.

3. The extractable support device according to claim 1 or 2, **characterized in that** the axis of rotation of the handle (26) extends vertically when the device is in the operating position.

4. The extractable support device according to any one of the foregoing claims, **characterized in that** it comprises a slide system comprising at least one groove (37,38) or a rib (39,40) provided on the outer surface of the top panel (15) of the plug-in unit (3) and the outer surface of the bottom panel (16) of the plug-in unit (3), these grooves (37,38) and ribs (39,40) being designed to collaborate with at least one rib (39,40), or respectively at least one groove (37,38), provided on the inner surface of the top panel (8) or the inner surface of the bottom panel (7) of the housing case (2), these grooves and ribs extending in substantially parallel manner to the direction of movement of the plug-in unit with respect to the housing case, and being designed to perform guiding of the plug-in unit with respect to the housing case when the plug-in unit is inserted in the housing case until locking of these two enclosures is performed by the above-mentioned locking means.

5. The extractable support device according to any one of the foregoing claims, **characterized in that** it comprises at least one longitudinal rib (41,42) extending in substantially parallel manner to the direction of movement of the plug-in unit with respect to the housing case and provided on the inner surfaces of two opposite panels (7,8) of the housing case (2) and/or the outer surfaces of two opposite panels (15,16) of the plug-in unit (3), said ribs being designed to collaborate with the smooth surfaces belonging to the plug-in unit and/or to the housing case situated facing said inner and outer surfaces, so as to minimize the friction surfaces between the plug-in unit and the housing case, a sliding adjustment being made between the facing surfaces of the other two panels of the two enclosures.

6. The extractable support device according to any one of claims 1 to 5, **characterized in that** the above-mentioned locking means comprise a protuberance (44) provided on the handle (26) designed to collaborate with an aperture (46) provided in a side panel of the plug-in unit (3) when the handle is in the second position corresponding to a connected position of the connectors of the two enclosures, so as to perform locking of the handle in position and consequently locking of the plug-in unit with respect to the housing case.

7. The extractable support device according to any one of the foregoing claims, **characterized in that** this device comprises three parts, respectively a first part comprising a housing case (2) comprising a part of the rack device, this part forming an integral part of the housing case, a second part comprising the plug-in unit (3) and the two pivot-pins (20,21) of the handle on the plug-in unit, said pivot-pins being moulded together with said plug-in unit, and a third part comprising the above-mentioned handle, said handle (26) comprising the second part of the rack device and, at its two ends, an aperture (22,23) designed to receive said pivot-pin, these three parts being produced by moulding.

8. The extractable support device according to any one of claims 1 to 7, **characterized in that** the top panel (8) and bottom panel (7) of the housing case (2) each comprise a lug (13,14) extending from the free edge of said panels in substantially parallel manner to the direction of insertion of the plug-in unit in the housing case, and **in that** the first part of the rack device extends in the form of a portion of a circle around the pivot-pins (20,21) of the handle whereas the second part is supported by the above-mentioned lugs (13,14) and extends linearly in parallel manner to the above-mentioned direction.

9. The extractable support device according to claim 1, **characterized in that** the above-mentioned toothed part comprises a tooth (28), whereas the above-mentioned crenelated part comprises a recess (31) of corresponding shape.

10. The extractable support device according to claim 7, **characterized in that** these three parts are made from plastic and/or metallic material.

11. The extractable support device according to any one of the foregoing claims, **characterized in that** the plug-in unit (3) is an enclosure supporting an electric relay (1).
